# EUROPÄISCHE PATENTSCHRIFT

(11) **EP 2 529 422 B1**
(45) Veröffentlichungstag und Bekanntmachung des Hinweises auf die Patenterteilung: **13.08.2014**
(21) Anmeldenummer: 10798140.9
(22) Anmeldetag: 29.12.2010
(51) Int. Cl.: H01L 41/047, H01L 41/083

(54) **PIEZOAKTOR MIT EINEM MEHRLAGENAUFBAU VON PIEZOLAGEN**
PIEZO ACTUATOR WITH A MULTILAYER STRUCTURE OF PIEZO LAYERS
ACTIONNEUR PIÉZOÉLECTRIQUE À STRUCTURE PIÉZOÉLECTRIQUE MULTICOUCHE

(30) Priorität: 27.01.2010 DE 102010001249
(43) Veröffentlichungstag der Anmeldung: 05.12.2012
(73) Patentinhaber: Robert Bosch GmbH, 70442 Stuttgart (DE)
(72) Erfinder: CROMME, Peter, 96050 Bamberg (DE); KOELLEIN, Robert, 96052 Bamberg (DE)
(86) Internationale Anmeldenummer: PCT/EP2010/070874
(87) Internationale Veröffentlichungsnummer: WO 2011/091938

(56) Entgegenhaltungen:
- EP-A1- 1 677 370
- JP-A- 2004 186 507

## Beschreibung

### Stand der Technik

Die Erfindung betrifft einen Piezoaktor mit einem Mehrlagenaufbau von Piezolagen und einem alternierenden Innenelektrodendesign nach den gattungsgemäßen Merkmalen des Anspruchs 1.

Ein solcher Piezoaktor ist beispielsweise aus der DE 102 36 986 A1 bekannt, der zur Betätigung eines mechanischen Bauteils bei Kraftstoffeinspritzsystemen in Kraftfahrzeugen eingesetzt werden kann. Hieraus ist bekannt, dass unter Ausnutzung des sogenannten Piezoeffekts ein Mehrlagenaufbau von Piezolagen jeweils aus einem Material mit einer geeigneten Kristallstruktur so angeordnet werden kann, dass bei Anlage einer elektrischen Spannung eine mechanische Reaktion der Piezolage erfolgt, die in Abhängigkeit von der Kristallstruktur und der Anlagebereiche der elektrischen Spannung einen Druck in eine vorgebbare Richtung darstellt.

Der Mehrlagenaufbau besitzt dabei ein alternierendes (interdigitales) Innenelektrodendesign, bei dem jede piezokeramische Lage zwischen zwei Innenelektroden eingefasst ist, über die eine elektrische Spannung angelegt werden kann und somit jeweils ein Piezoelement bildet. Aufgrund der elektrischen Spannung führen die Piezoelemente jeweils kleine Hubbewegungen in Richtung des Potenzialgefälles aus, die sich zum Gesamthub des Piezoaktors addieren.

Diese bekannten Piezoaktoren weisen dabei in der Regel eine einheitliche Schichtdicke der Piezolagen über den gesamten aktiven Bereich auf. Kopf- und fußseitig schließt sich allerdings an diesen aktiven Bereich ein sogenannter passiver Bereich an, bei dem auch im Betrieb des Piezoaktors kein elektrisches Feld anliegt (E=O). Das interdigitale Piezoaktordesign ist dabei insbesondere an den Übergängen vom aktiven auf den passiven Bereich im Kopf und Fuß anfällig gegen Rissbildung. Besonders kritisch sind hier Risse in der Aktorlängsrichtung. Die Anfälligkeit hinsichtlich der Rissbildung kann im Wesentlichen auf zwei Ursachen reduziert werden, nämlich durch einen sehr abrupten Übergang von aktiv auf passiv und durch eine diskontinuierliche Materialzusammensetzung (Dotierstoffe) der Piezokeramik des Piezoaktors in aktiven und inaktiven Bereichen.

Insbesondere aufgrund einer Querkontraktion der Piezokeramik unter Einwirkung eines elektrischen Feldes entstehen an den Aktiv/Passiv-Übergängen im Betrieb des Piezoaktors mechanische Zugspannungen, die zur Bildung von Axialrissen führen können. Entlang dieser Risse treten in der Regel elektrische Kurzschlüsse als Sekundarfehler auf, die unter Umständen zum elektrischen Ausfall des Piezoaktors führen können.

Es ist an sich bekannt, dass hauptsächlich eine Reduzierung der elektrischen Feldbelastung an den Aktiv/Passiv-Übergängen durch eine Erhöhung der Dielektrikumsdicke in diesen Bereichen vorgenommen wird. Diese Maßnahme kann dabei mit einer Materialhomogenisierung in dem Übergangsbereich kombiniert werden. Durch diese Maßnahmen ist eine Designänderung des Piezoaktors zu einem frühen Zeitpunkt in der Prozesskette bei der Herstellung notwendig, d. h. insbesondere beim sogenannten Grünaufbau der Grünfolien der Piezokeramik. Dadurch ist eine spätere flexible Anpassung der elektrischen Feldbelastung an den Aktiv/Passiv-Übergängen des Piezoaktors beispielsweise in Abhängigkeit der eingesetzten Rohstoffchargen der Grünfolien nicht möglich.

EP 1 677 370 A1 zeigt ein piezoelektrisches Element mit einer Außenelektrode, die direkt an den Innenelektroden angeordnet ist, wobei auf der Außenelektrode ein elektrisch leitendes Haftmittel aufgebracht ist, welches für verbesserte leitende Eigenschaften des piezoelektrischen Elements im Betrieb sorgt.

JP 2004 186507 A zeigt eine piezoelektrische Vorrichtung, wobei die Außenelektroden in eine Ag/Pd-Paste eingebettet sind, die für eine elektrische Verbindung zwischen den Innen- und der jeweiligen Außenelektrode sorgt.

Die zuvor beschriebenen Probleme sind in der praktischen Anwendung durchaus bedeutend, da die elektromechanischen Eigenschaften der Piezoaktoren bei konstanten Herstellbedingungen im starken Maße von den verwendeten Rohstoffchargen beeinflusst werden.

### Offenbarung der Erfindung

Die Erfindung geht von einem Piezoaktor mit einem Mehrlagenaufbau aus Piezolagen aus, die jeweils zwischen Innenelektroden wechselnder Polarität eingefasst sind und bei dem die Innenelektroden über Außenelektroden mit jeweils einer unterschiedlichen Polarität einer elektrischen Spannung dadurch beaufschlagt sind, dass jeweils eine Außenelektrode mit jeweils den Innenelektroden einer Polarität kontaktiert ist, wobei Piezoaktor kann dabei Bestandteil eines Piezoinjektors zur Steuerung der Kraftstoffeinspritzung bei einem Verbrennungsmotor sein. Es kann als eine Aufgabe der Erfindung angesehen werden, eine Reduzierung von mechanischen Zugspannungen an den Aktiv/Passiv-Übergängen des Piezoaktors ohne grundlegende Veränderungen des Piezoaktordesigns vorzunehmen.

Gemäß der Erfindung sind in Übergangsbereichen zwischen den aktiven und passiven Bereichen zwischen den Außenelektroden und den Innenelektroden sich im Lagenaufbau erstreckende elektrische Widerstandsschichten angeordnet, mit denen eine selektive Spannungsreduzierung in Richtung der Innenelektroden vom aktiven Bereich zum passiven Bereich hin bewirkbar ist. Die Widerstandsschichten können dabei vom aktiven zum passiven Bereich hin zum Beispiel eine sich selektiv vergrößernde Dicke aufweisen. Sie sind direkt mit den Innenelektroden kontaktiert, außen mit einer Grundmetallisierung umgeben und sind weiter außen mit Außenelektroden, vorzugsweise Siebelektroden, umfasst. Die Widerstandsschichten können sich dabei stufenförmig, linear oder sonst wie ansteigend vom aktiven zum passiven Bereich hin vergrößern oder auch einen Widerstandsgradienten bei homogener Geometrie aufweisen.

Kern der Erfindung ist somit ein Aufbringen mindestens einer Widerstandsschicht zwischen den ersten kopf- und/oder fußseitigen Innenelektroden und der Grundmetallisierung bei ansonsten unverändertem Piezoaktordesign. Die jeweilige Widerstandschicht reduziert den elektrischen Spannungsabfall in der Piezokeramik und somit das elektrische Feld in der Dielektrikumsschicht. Als Folge sinkt die Querkontraktion in den ersten aktiven Schichten und die Höhe der auftretenden Zugspannungen wird hier deutlich reduziert.

Durch die erfindungemäß vorgeschlagene Anbringung der elektrischen Widerstandsschicht wird sowohl die Polarisations- als auch die Betriebsspannung der derartig bedeckten Piezolagen reduziert, was zu einer geringeren lateralen Kontraktion und entsprechend geringeren Zugspannung und zu weniger Keramikschädigungen führt. Dabei kann durch eine geeignete Material- und Schichtdickenwahl der Widerstandsschicht eine minimale Werkstoffbelastung des Piezoaktors erreicht werden.

Da das Aufbringen der Widerstandschicht technologisch in der Regel nicht sehr aufwändig ist, ist eine entsprechende Anpassung der Widerstandschicht in Abhängigkeit der eingesetzten Rohstoffchargen der Piezokeramik, z. B. Bleizirkonat-Titanat (PZT), auf einfache Weise möglich. Je nach den elektromechanischen Eigenschaften des eingesetzten PZTs kann durch Variation der Größe und/oder der Zusammensetzung der Widerstandschicht eine optimale Reduzierung der mechanischen Spannungen an den Aktiv/Passiv-Übergängen eingestellt werden.

Mit der Erfindung wird somit ein Konzept vorgeschlagen, wie die elektrische Feldbelastung an den Aktiv/Passiv-Übergängen eines piezokeramischen Aktors auf einfache Weise zu einem relativ späten Zeitpunkt in der Prozesskette bei der Herstellung flexibel gesteuert werden kann. Durch dieses Konzept steigt sowohl die Robustheit der Piezoaktoren gegenüber Rissen im Betrieb des Piezoaktors als auch während der Herstellung, insbesondere in den erwähnten Übergangsbereichen. Eine aufwändige Anpassung der Stapelfolge der Piezolagen, wie sie sonst bei einer lokalen Erhöhung der Dielektrikumsdicke der Piezolagen notwendig ist, kann somit in vorteilhafter Weise entfallen.

### Kurze Beschreibung der Zeichnung

Ein Ausführungsbeispiel der Erfindung wird im Folgenden anhand der Figuren der Zeichnung näher beschrieben. Es zeigen:
Figur 1 eine Darstellung eines Piezoaktors mit Innen- und Außenelektroden und Widerstandsschichten in den Aktiv/Passiv-Übergängen.
Figur 2 eine Detaildarstellung eines Aktiv/Passiv-Übergangs zur Erläuterung der mechanischen Spannungen.
Figur 3 eine Detaildarstellung eines Aktiv/Passiv-Übergangs mit der erfindungsgemäßen Widerstandsschicht.

### Weg zur Ausführung der Erfindung

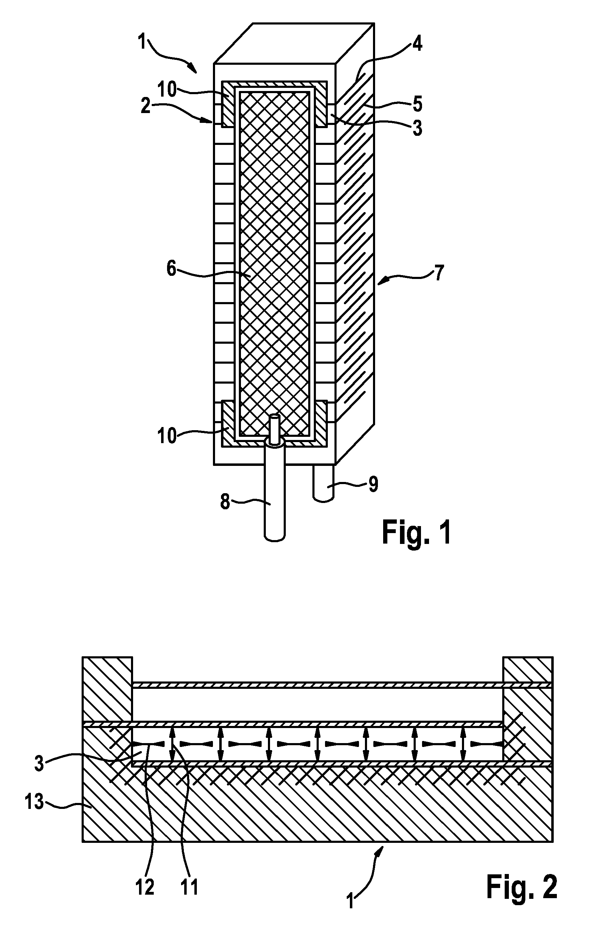

Ein in Figur 1 dargestellter Piezoaktor 1 umfasst mehrere als Mehrlagenaufbau übereinandergestapelte Piezoelemente 2, die jeweils aus Piezolagen 3 aus Piezokeramik und diese einschließende Innenelektroden 4 und 5 bestehen. Der Piezoaktor 1 kann beispielsweise Bestandteil eines Piezoinjektors zur Steuerung der Kraftstoffeinspritzung bei einem Verbrennungsmotor sein. Die Innenelektroden 4 und 5 der Piezoelemente sind mit Außenelektroden 6 und 7 (Außenelektrode 7 hier nicht sichtbar auf der Rückseite des Piezoaktors 1) wechselseitig an eine Spannungsquelle über Anschlüsse 8 und 9 angeschlossen, sodass unter Ausnutzung des Piezoeffekts bei Anlage der elektrischen Spannung an die jeweiligen Innenelektroden 4 und 5 über die zwischenliegenden Piezolagen 3 eine mechanische Reaktion des Piezoaktors 1 in Stapelrichtung des Mehrlagenaufbaus bewirkt werden kann. Weiterhin sind Widerstandsschichten 10 vorhanden, die nachfolgend näher erläutert werden.

Für eine Reduzierung der mechanischen Spannungen an der jeweiligen Grenzfläche von einem passiven Bereich zu einer aktiven Piezolage 3 ist eine Verminderung der Dehnung der Piezokeramik der entsprechenden aktiven Piezolage 3 in diesem Bereich erforderlich. Die hier auftretenden mechanischen Spannungen sind in Figur 2 mit den vertikal erzeugten Dehnungen 11 und die dadurch bedingten horizontalen Kontrahierungen 12 in der ersten aktiven Piezolage 3 an der Grenze zum passiven Bereich 13 gezeigt.

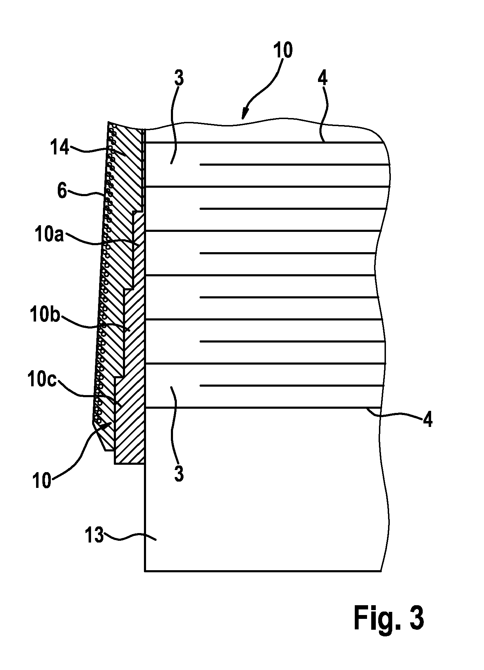

Aus Figur 3 ist in einer Detaildarstellung eines Aktiv/Passiv-Übergangs bei einem ausschnittsweise dargestellten Piezoaktor 1 an einer Kontaktseite mit den seitlichen Kontaktstellen der Innenelektroden 4 im Fußbereich des Piezoaktors 1 zu entnehmen. Die Kontaktierungen auf der anderen nicht dargestellten Seite mit den Innenelektroden entgegengesetzter Polarität kann dabei, je nach Ausführungsform, auch identisch ausgeführt werden.

Beim Ausführungsbeispiel nach der Figur 3 ist die Widerstandsschicht 10 (vgl. Fig.1) angeordnet, die im Übergangsbereich vom aktiven mit Innenelektroden 4 und 5 versehenen Bereich zu dem passiven Bereich 13 so ausgeführt ist, dass hier eine selektive Spannungsreduzierung in Richtung vom aktiven Bereich zum passiven Bereich 13 hin bewirkbar ist. Die einzelnen Widerstandsschichten 10a, 10b und 10c weisen dazu bei dieser Ausführungsform vom aktiven zum passiven Bereich hin eine sich stufenartig vergrößernde Dicke und dadurch einen sich vergrößernden Widerstandswert auf. Über die Widerstandsschichten 10a, 10b und 10c, und daran anschließend über die Kontaktierung der Innenelektroden 4 und 5, ist eine Grundmetallisierung 14 gezogen und weiter außen ist hier sichtbar die Außenelektrode 6 (vgl. Fig.1) als Siebelektrode angeordnet.

Beim dargestellten Ausführungsbeispiel der Erfindung wird somit durch das Zwischenschalten der Widerstandsschicht 10 zwischen den jeweils im aktiven Bereich ersten kopf- und fußseitigen Innenelektroden 4 und der Grundmetallisierung 14 bei ansonsten unverändertem Piezoaktordesign der elektrische Spannungsabfall in der Piezokeramik der Piezolagen 3 und somit das elektrische Feld in der entsprechenden Dielektrikumsschicht reduziert. Als Folge sinkt dadurch die Querkontraktion, bzw. die horizontalen Kontrahierungen 12 (vgl. Fig. 2), in den ersten aktiven Piezolagen 3 und die Höhe der auftretenden nachteiligen Zugspannungen wird deutlich reduziert.

Ausgehend von der in der Figur 1 gezeigten Ausführungsform sind eine Vielzahl von Designvarianten bei der Ausführung des Piezoaktors 1 mit den Widerstandsschichten 10 möglich.

Je nach Bedarf kann nur der kopfseitige Aktiv/Passiv-Übergang, nur der fußseitige Aktiv/Passiv-Übergang oder es können beide mit der Widerstandsschicht 10 versehen werden.

Es kann dabei eine kostengünstige unipolare Spannungsreduzierung dadurch vorgenommen werden, dass die Widerstandsschicht 10, die die Dehnung der anliegenden Innenelektroden 4 und 5 verringert, nur einseitig auf die positive oder negative Kontaktseite der Piezoelementen 2 aufgebracht wird, wies der Figur 1 an der Außenelektrode 6 zu entnehmen ist.

Bei einer bipolaren Spannungsreduzierung werden die Widerstandsschichten 10 auf die positive und auf die negative Kontaktseite der Piezoelemente 2 aufgebracht. Durch die Verteilung der Spannungsabfälle auf zwei Widerstandsschichten 10 wird dabei auch die lokale Erwärmung in den aufgebrachten Widerstandsschichten 10 im Kopf- bzw. Fußbereich des Piezoaktors 1 reduziert.

Durch die angepasste Spannungsreduzierung nach der Figur 3 wird die lokale Belastung der Piezolagen 3 durch Zugspannungen stark reduziert, indem die Kräfte noch gleichmäßiger auf mehrere Piezolagen 3 verteilt werden. Dafür ist der Widerstandswert der Widerstandsschicht 10a, 10b und 10c nicht über jeder bedeckten Innenelektrode 4 oder 5 gleich, sondern steigt zu den Stirnflächen am Kopf und/oder Fuß des Piezoaktors 1 an.

Alternativ zu der Ausführungsform nach der Figur 3 kann neben einer geometrischen Veränderung der Widerstandsschicht 10 auch eine Änderung des Widerstandsgradienten im Material der Widerstandsschicht 10 bei homogener Geometrie erfolgen. Die Widerstandsschicht 10 kann beispielsweise durch einen Sieb- oder Schablonendruck aufgebracht werden. Eine hohe Flexibilität bezüglich der Aufbringung einer derartigen Widerstandschicht 10 ist mit einer sogenannten Jet-Printing-Technologie erreichbar, bei der das Material ähnlich wie bei einem Tintenstrahldrucker aufgespritzt wird.

Als Material für die Widerstandschicht 10 kann eine Ag/Pd-Paste verwendet werden, welche zur Erhöhung des elektrischen Widerstandes beispielsweise mit nichtleitenden und/oder schlecht leitenden Partikeln gefüllt ist. Bei den nichtleitenden Partikeln kann es sich vorzugsweise um oxidische Partikel oder sog. Glasbildner handeln, die mit dem Ag/Pd ein Ag/Pd/Glas-Komposit bilden. Durch die Ag/Pd Menge kann bei derartigen Kompositen der elektrische Widerstand der Widerstandsschicht 10 auf einfache Weise angepasst werden.

## Patentansprüche

1. Piezoaktor mit einem Mehrlagenaufbau aus Piezolagen (3), die jeweils zwischen Innenelektroden (4,5) wechselnder Polarität eingefasst sind und die Innenelektroden über Außenelektroden (6,7) mit jeweils einer unterschiedlichen Polarität einer elektrischen Spannung dadurch beaufschlagt sind, dass jeweils eine Außenelektrode (6,7) mit jeweils den Innenelektroden (4,5) einer Polarität kontaktiert ist, wobei aktive und passive Bereiche im Mehrlagenaufbau des Piezoaktors vorhanden sind, wobei in mindestens einem Übergangsbereich zwischen den aktiven Piezolagen (3) und einem passiven Bereich (13) zwischen der Außenelektrode (6,7) und den Innenelektroden (4,5) eine elektrische Widerstandsschicht (10;10a,10b,10c) angeordnet ist, mit der hier selektiv eine Spannungsreduzierung bewirkbar ist, **dadurch gekennzeichnet, dass** die Widerstandsschicht (10;10a,10b,10c) in der Erstreckungsrichtung des Mehrlagenaufbaus von den aktiven Piezolagen (3) hin zum passiven Bereich (13) einen sich vergrößernden Widerstandswert aufweist.

2. Piezoaktor nach Anspruch 1, **dadurch gekennzeichnet, dass** die Widerstandsschicht (10;10a,10b,10c) in der Erstreckungsrichtung des Mehrlagenaufbaus von den aktiven Piezolagen (3) hin zum passiven Bereich (13) hin eine sich stetig oder stufenförmig vergrößernde Dicke aufweist.

3. Piezoaktor nach Anspruch 1, **dadurch gekennzeichnet, dass** die Widerstandsschicht (10;10a,10b,10c) in der Erstreckungsrichtung des Mehrlagenaufbaus von den aktiven Piezolagen (3) hin zum passiven Bereich (13) hin einen sich stetig oder stufenförmig verändernden Widerstandswert durch eine Änderung der Materialzusammensetzung bei homogener Geometrie aufweist.

4. Piezoaktor nach einem der vorhergehenden Ansprüche, **dadurch gekennzeichnet, dass** über die Widerstandsschicht (10;10a,10b,10c) und daran anschließend über die Kontaktierungen der Innenelektroden (4,5) eine Grundmetallisierung (14) gezogen ist und weiter mit Außenelektroden (6,8) umfasst ist.

5. Piezoaktor nach Anspruch 4, **dadurch gekennzeichnet, dass** die Außenelektroden (6,7) siebförmig sind.

6. Piezoaktor nach einem der vorhergehenden Ansprüche, **dadurch gekennzeichnet, dass** die Widerstandsschicht (10;10a,10b,10c) einseitig oder beidseitig, nur im Fußbereich, nur im Kopfbereich oder an beiden Enden des Piezoaktors (1) angebracht sind.

7. Piezoaktor nach einem der vorhergehenden Ansprüche, **dadurch gekennzeichnet, dass** die Piezolagen (3) aus Bleizirkonat-Titanat (PZT) bestehen.

8. Piezoaktor nach einem der vorhergehenden Ansprüche, **dadurch gekennzeichnet, dass** die mindestens eine Widerstandsschicht (10;10a,10b,10c) aus einer Ag/Pd-Paste gebildet ist.

9. Piezoaktor nach Anspruch 8 in Verbindung mit Anspruch 4, **dadurch gekennzeichnet, dass** die Ag/Pd-Paste mit nichtleitenden oder selektiv leitenden Partikeln derart versetzt ist, dass sich stetig oder stufenförmig veränderter Widerstandswert bei homogener Geometrie ergibt.

10. Verwendung eines Piezoaktor nach einem der vorhergehenden Ansprüche, **dadurch gekennzeichnet, dass** der Piezoaktor (1) Bestandteil eines Piezoinjektors zur Steuerung der Kraftstoffeinspritzung bei einem Verbrennungsmotor ist.

## Claims

1. Piezo actuator with a multilayer structure of piezo layers (3), which are respectively enclosed between inner electrodes (4, 5) of changing polarity, to which an electrical voltage is applied via outer electrodes (6, 7), each of a different polarity, in such a way that in each case an outer electrode (6, 7) is in contact with the inner electrodes (4, 5) of one polarity, active and passive regions being present in the multilayer structure of the piezo actuator and an electrical resistance layer (10; 10a, 10b, 10c) being arranged in at least one transitional region between the active piezo layers (3) and a passive region (13) between the outer electrode (6, 7) and the inner electrodes (4, 5), allowing a voltage reduction to be selectively brought about here, **characterized in that** the resistance layer (10; 10a, 10b, 10c) has an increasing resistance value in the direction of extent of the multilayer structure from the active piezo layers (3) towards the passive region (13).

2. Piezo actuator according to Claim 1, **characterized in that** the resistance layer (10; 10a, 10b, 10c) has a steadily or stepwise increasing thickness in the direction of extent of the multilayer structure from the active piezo layers (3) towards the passive region (13).

3. Piezo actuator according to Claim 1, **characterized in that** the resistance layer (10; 10a, 10b, 10c) has a steadily or stepwise changing resistance value in the direction of extent of the multilayer structure from the active piezo layers (3) towards the passive region (13) as a result of a changing of the material composition with a homogeneous geometry.

4. Piezo actuator according to one of the preceding claims, **characterized in that** a base metallization (14) is drawn over the resistance layer (10; 10a, 10b, 10c), and subsequently over the contacts of the inner electrodes (4, 5), and is further enclosed by outer electrodes (6, 8).

5. Piezo actuator according to Claim 4, **characterized in that** the outer electrodes (6, 7) are in the form of screens.

6. Piezo actuator according to one of the preceding claims, **characterized in that** the resistance layer (10; 10a, 10b, 10c) is provided on one side or on both sides, only in the bottom region, only in the top region or at both ends of the piezo actuator (1).

7. Piezo actuator according to one of the preceding claims, **characterized in that** the piezo layers (3) consist of lead zirconate titanate (PZT).

8. Piezo actuator according to one of the preceding claims, **characterized in that** the at least one resistance layer (10; 10a, 10b, 10c) is formed from an Ag/Pd paste.

9. Piezo actuator according to Claim 8 in conjunction with Claim 4, **characterized in that** the Ag/Pd paste is mixed with nonconducting or selectively conducting conducting particles in such a way as to obtain a steadily or stepwise changing resistance value with a homogeneous geometry.

10. Use of a piezo actuator according to one of the preceding claims, **characterized in that** the piezo actuator (1) is a component part of a piezo injector for controlling the fuel injection in an internal combustion engine.

## Revendications

1. Piézo-actionneur doté d'une structure multicouche constitué de couches piézo (3) serties entre des électrodes intérieures (4, 5) de polarité alternée,
une tension électrique pouvant être appliquée sur les électrodes intérieures par l'intermédiaire d'électrodes extérieures (6, 7) de polarités différentes, par mise en contact d'une électrode extérieure (6, 7) avec les électrodes intérieures (4, 5) d'une polarité,
la structure multicouche du piézo-actionneur présentant des parties actives et des parties passives,
une couche de résistance électrique (10; 10a, 10b, 10c) qui permet d'obtenir sélectivement une réduction de tension étant disposée dans au moins une partie de transition entre les couches piézo-actives (3) et une partie passive (13) située entre l'électrode extérieure (6, 7) et les électrodes intérieures (4, 5),
**caractérisé en ce que**
la couche de résistance (10; 10a, 10b, 10c) présente une valeur de résistance qui augmente dans la direction d'extension de la structure multicouche des couches piézo-actives (3) à la partie passive (13).

2. Piézo-actionneur selon la revendication 1, **caractérisé en ce que** l'épaisseur de la couche de résistance (10; 10a, 10b, 10c) augmente de manière continue ou par gradins dans la direction d'extension de la structure multicouche des couches prézo-actives (3) à la partie passive (13).

3. Piézo-actionneur selon la revendication 1, **caractérisé en ce que** la valeur de résistance de la couche de résistance (10; 10a, 10b, 10c) augmente de manière continue ou par gradins dans la direction d'extension de la structure multicouche des couches piézo-actives (3) à la partie passive (13) varie de manière progressive ou par gradins suite à une modification de la composition du matériau tout en conservant une géométrie homogène.

4. Piézo-actionneur selon l'une des revendications précédentes, **caractérisé en ce qu'**une métallisation de base (14) est appliquée au-dessus de la couche de résistance (10; 10a, 10b, 10c) et en position adjacente au-dessus des contacts des électrodes intérieures (4, 5) et est en outre dotée d'électrodes extérieures (6, 8).

5. Piézo-actionneur selon la revendication 4, **caractérisé en ce que** les électrodes extérieures (6, 7) ont la forme de tamis.

6. Piézo-actionneur selon l'une des revendications précédentes, **caractérisé en ce que** la couche de résistance (10; 10a, 10b, 10c) est appliquée sur une face ou sur les deux faces, uniquement dans la partie de pied, uniquement dans la partie de tête ou aux deux extrémités du piézo-actionneur (1).

7. Piézo-actionneur selon l'une des revendications précédentes, **caractérisé en ce que** les couches piézo (3) sont constituées de zirconate-titanate de plomb (PZT).

8. Piézo-actionneur selon l'une des revendications précédentes, **caractérisé en ce que** la ou les couches de resistance (10; 10a, 10b, 10c) sont formées d'une pâte d'Ag/Pd.

9. Piézo-actionneur selon la revendication 8 en association avec la revendication 4, **caractérisé en ce que** la pâte d'Ag/Pd est additionnée de particules non conductrices ou sélectivement conductrices de manière à obtenir une valeur de résistance qui varie progressivement ou par gradins tout en conservant une géométrie homogène.

10. Utilisation d'un piézo-actionneur selon l'une des revendications précédentes, **caractérisée en ce que** le piézo-actionneur (1) fait partie d'un piézo-injecteur destiné à commander l'injection de carburant dans un moteur à combustion interne.
